# EUROPEAN PATENT SPECIFICATION

(11) **EP 3 782 201 B1**
(45) Date of publication and mention of the grant of the patent: **11.06.2025**
(21) Application number: 19717486.5
(22) Date of filing: 12.04.2019
(51) Int. Cl.: H10F 19/80

(54) **METHOD OF MANUFACTURING PHOTOVOLTAIC MODULES**
VERFAHREN ZUR HERSTELLUNG VON PHOTOVOLTAIKMODULEN
PROCÉDÉ DE FABRICATION DE MODULES PHOTOVOLTAÏQUES

(30) Priority: 16.04.2018 WO PCT/EP2018/059637
(43) Date of publication of application: 24.02.2021
(73) Proprietor: CSEM Centre Suisse d'Electronique et de Microtechnique SA - Recherche et Développement, 2002 Neuchâtel (CH)
(72) Inventor: LI, Hengyu, 2022 Bevaix (CH); ESCARRE PALOU, Jordi, 2000 Neuchâtel (CH); SÖDERSTRÖM, Karin, 2000 Neuchâtel (CH); BULLIARD, Xavier, 1690 Lussy (CH); PERRET-AEBI, Laure-Emmanuelle, 2000 Neuchâtel (CH); BALLIF, Christophe, 2000 Neuchâtel (CH)
(74) Representative: Patentsmith SA
(86) International application number: PCT/EP2019/059422
(87) International publication number: WO 2019/201773

(56) References cited:
- EP-A1- 2 144 301
- EP-A1- 2 804 223
- WO-A1-2012/152812
- WO-A1-2016/118885
- WO-A2-2009/089236
- WO-A2-2012/021460
- JP-A- 2001 308 360
- US-A1- 2012 024 348
- US-A1- 2012 247 541
- US-A1- 2015 031 812

## Description

### Technical Field

The present invention relates to the technical field of photovoltaic modules. More particularly, it relates to coloured photovoltaic modules particularly suited for building-integrated applications, as well as to methods of manufacture thereof.

### State of the art

The natural colour of photovoltaic (PV) devices, also referred to as solar cells or solar panels, tends to be near black, often with a purple or indigo tint, with a clearly-defined pattern of the individual cells being visible. When such PV devices are mounted on buildings, they can be unsightly, and it is often unacceptable to use them directly as building cladding for this reason.

In order to overcome this issue, coloured PV devices have been proposed, which enable their integration into the structure of a building, notably as exterior cladding.

Document US 9,281,186 discloses a film placed on the front sheet of the PV device to modify the appearance of the module. However, this film requires a specific profile which necessitates alignment with the geometry of the individual PV cells making up the module, and relies on a complex design involving facets in the front sheet and embedded elements in the inactive part of the module.

US 2014/326292 discloses a PV device comprising a graphic film placed inside the module. This film is printed with a colour or texture, and requires a selective reflector layer to limit the impact of the film on the efficiency of the module.

US 9,276,141, WO2016/118885 and US 8,513,517 disclose decorative film overlays placed on or within a PV module.

EP2793271 describes a white photovoltaic module in which an interference filter is formed on an intermediate layer deposited on the light-incident side of the photovoltaic module so as to reflect a certain amount of light over the whole visible spectrum. Specialised equipment and techniques are required to produce this interference filter.

US2012/247541 describes printing on top of an encapsulation layer

However, all of these prior art solutions are either complex, or require extra layers to be applied to modules. Essentially, for each additional layer added to a module, the risk of delamination of the module increases since there are more interfaces between layers which can separate. Furthermore, special manufacturing techniques or equipment may be required.

JP 2001 308360 A suggests including a pigmented encapsulation film either inside a PV module, between the front encapsulant and the front sheet, or on top of the front cover to give the PV module a colored appearance.

WO2009/089236 proposes a solution to this problem. In the embodiment of figure 7 of this document, the front encapsulation layer itself comprises pigment particles randomly dispersed therein. This hence does away with the need for extra coloured film layers in addition to the front encapsulation layer, but presents a whole different set of problems. Since the encapsulants used in this document are conventional, this can lead to significant nonhomogeneity of the coloration. Furthermore, in extreme cases, excessive encapsulant flow can lead to significant thickness variations within the module, particularly with respect to zones in which a PV cell is present and zones in which no PV cell is present. This again results in undesired colour variations across the module.

The aim of the present invention is thus to at least partially overcome the above-mentioned drawbacks of the prior art.

### Disclosure of the invention

More specifically, the invention relates to a method of manufacturing a photovoltaic module according to claim 1 comprising the steps of:
- providing a lamination device such as a heated vacuum bag laminator or other suitable device;
- disposing in said lamination device a layer stack comprising:
- a front sheet intended to be arranged on a light incident side of said photovoltaic module, the front sheet being made of e.g. glass, transparent ceramic, polymer or other suitable transparent material;
- a back sheet intended to be arranged on an opposite side of said photovoltaic module to said front sheet, the back sheet being made of e.g. glass, transparent ceramic, polymer or other suitable transparent material;
- a photovoltaic conversion device of any convenient form disposed between said front sheet and said back sheet;
- at least one front encapsulation layer of suitable thermoplastic or at least partially cross-linked polymer disposed between said photovoltaic conversion device and said front sheet, said front encapsulation layer comprising pigment particles distributed therein. It is noted that a rear encapsulant may also be provided between the PV conversion device and the back sheet if desired.
- applying heat and pressure to said layer stack so as to assemble it into said photovoltaic module by means of fusing and/or cross-linking the encapsulation layer(s).

According to the invention, said front encapsulation layer comprises a first film and a second film, said first film being situated closer to said front sheet than said second film and comprising a higher concentration of pigment particles than said second film. In other words, the second film comprises substantially no pigment particles, or at least less particles than the first film. Furthermore, said first film is at least partially cross-linked and has a complex viscosity greater than 20,000 Pa.s at 85°C, greater than 15,000 Pa.s at 105°C, and greater than 5,000 Pa.s at 165°C , and wherein said second film has a complex viscosity less than 100,000 Pa.s at 85°C, less than 20,000 Pa.s at 105°C, and less than 10,000 Pa.s at 165°C, the 165°C conditions being optional if lamination temperature is less than 165°C. If the lamination temperature is less than 165°C, the conditions at 165°C are optional. Likewise, these overlapping ranges are not incompatible with the statement several paragraphs ago concerning the viscosity criterion to be fulfilled at the temperature of lamination.

The particles give a coloration to the module making it suitable for use e.g. as building cladding, and furthermore scatter a certain amount of incoming light which helps to hide the structure of the photovoltaic conversion device. The two-film structure, which results in the two zones mentioned above, limits or even completely eliminates migration and agglomeration of the pigment particles in the first film during lamination, giving the finished module the desired colour distribution, which is typically homogeneous, but it can be patterned. If the second film also contains pigment particles, any migration of the lower concentration of pigment therein is masked by the more denselypigmented first film. Furthermore, no special manufacturing techniques are required since the PV module can be assembled with a standard lamination process, and using standard front sheets without special features such as textures, structuration or similar.

In an alternative process, the method of manufacturing a photovoltaic module according to claim 2 comprises the steps of:
- providing a lamination device such as a heated vacuum bag laminator or other suitable device;
- disposing in said lamination device a layer stack comprising:
- a prefabricated photovoltaic module;
- at least one front encapsulation layer disposed on a side of said prefabricated photovoltaic module intended to receive incident light, said front encapsulation layer comprising pigment particles distributed therein;
- a front sheet arranged on a light incident side of said at least one front encapsulation layer;
- applying heat and pressure to said layer stack so as to assemble it into said photovoltaic module by fusing and/or cross-linking the encapsulant material.

Again, the front encapsulation layer comprises a first film and a second film, said first film being situated closer to said front sheet than said second film and comprising a higher concentration of pigment particles than said second film.

The advantages of the present invention can thus be applied to pre-existing, prefabricated PV modules. The module of the invention can thus be fabricated to order based on existing, commercially-available modules. This is particularly efficient since coloured modules can then easily be fabricated to order based on a stock of standard, commercially-available modules.

Advantageously, said first film has a higher viscosity than said second film at all times during said application of heat and pressure, i.e. during lamination. As a result, the pigment particles distributed therein are more strongly prevented from migrating and agglomerating.

Advantageously, said first film has a tan δ value of less than 0.8, and said second film has a tan δ value of at least 0.9, preferably at least 1.2, during said application of heat and pressure. Furthermore, at least at the temperature of lamination, the viscosity of the second film is at most 80%, preferably at most 50%, of the viscosity of the first film. This is also the case approaching the lamination temperature. This ensures that the first film acts like a solid during lamination, preventing migration of pigment particles and maintaining a substantially constant thickness of the pigment-containing layer, whereas the second film acts like a liquid.

Advantageously, said layer stack may further comprise a graphic film disposed on said light incident side of said front sheet. The graphic film can thus be incorporated directly into the module during lamination. Alternatively, it can be applied later, after lamination.

Advantageously, at least some, preferably at least 50% or even at least 75%, of said pigment particles have a diameter ranging from 100 nm to 1 µm, preferably 300-700 nm, more preferably 400-600 nm. The diameter of the particles can be optimised for the desired optical properties of the front encapsulant layer. Likewise, the pigment particles can be provided in said front encapsulation layer in a mass concentration ranging from 0.01 to 10 parts per hundred of resin, which can again be tuned to optimise the desired properties.

Advantageously, said pigment comprises at least one of: Zinc-based pigments (such as Zinc oxide or zinc chromate), Titanium-based pigments (such as Titanium oxide or titanium yellow), Iron-based pigments (such as iron oxides or Prussian blue), Chromium-based pigments (such as chromium oxides), Bismuth-based pigments (such as bismuth vanadate), Cobalt-based pigments (such as cobalt blue or cobalt stannate or Cobalt/lithium/Titanium oxides), Aluminium-based pigments (such as complex sulphur-containing sodium silicates), Tin-based pigments (such as stannic sulfide), or Copper-based pigments.

Advantageously, said front encapsulation layer is manufactured by mixing said pigment particles with a base resin, and extruding said front encapsulation layer as a film.

### Brief description of the drawings

Further details of the invention will appear more clearly upon reading the description below, in connection with the following figures which illustrate:
- Figure 1: a schematic cross-sectional view of a photovoltaic module manufactured according to the invention;
- Figure 2: a schematic cross-sectional view of a further photovoltaic module manufactured according to the invention;
- Figure 3: a schematic cross-sectional view of part of a photovoltaic module manufactured according to the invention provided with a graphic film;
- Figure 4: a schematic representation of the manufacture of a photovoltaic module according to the invention by means of a lamination device;
- Figures 5-8: graphs of experimental results obtained with photovoltaic modules similar to those produced by the method of the invention;
- Figure 9: a schematic representation of a building structure provided with a photovoltaic module manufactured according to the invention;
- Figure 10: a graph of complex viscosity against temperature for an example pair of front encapsulation layer films; and
- Figure 11: a graph of Tan δ values for the same films.

### Embodiments of the invention

It should be noted in the following that, unless explicitly stated that a particular layer is disposed directly on the adjacent layer, it is possible that one or more intermediate layers can also be present between the layers mentioned. As a result, "on" should be construed by default as meaning "directly or indirectly on". Furthermore, patterning of certain layers, connectors and so on are not represented since they are well-known to the skilled person.

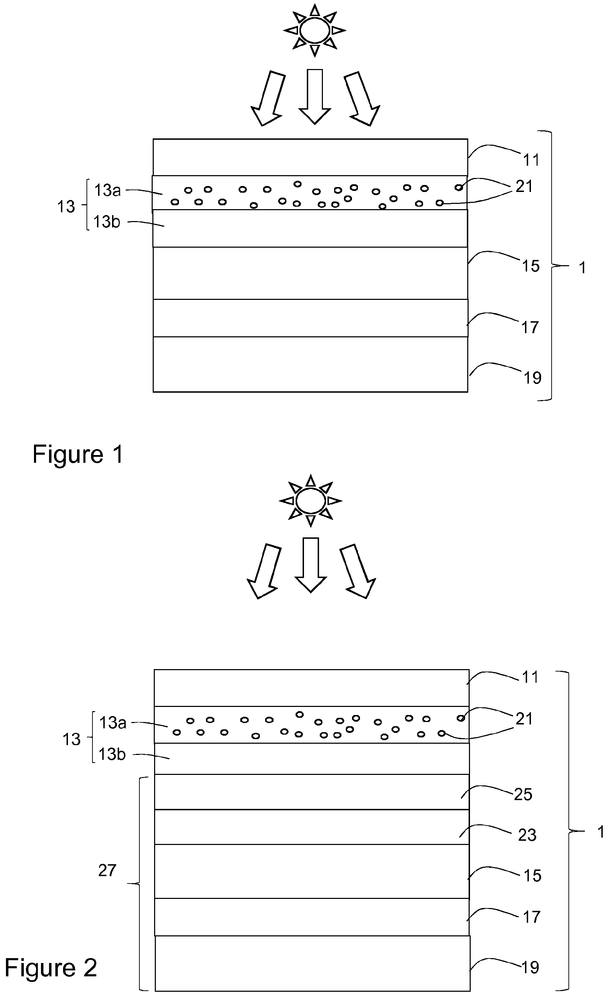

Figure 1 illustrates a first embodiment of a photovoltaic (PV) module 1 manufactured according to the invention.

This module 1 comprises a front sheet 11, on the light incident side of the module 1, intended to be illuminated when in use (as indicated in the figures by means of a sun symbol), and a back sheet 19, on the opposite side of the module 1 to the front sheet 11. The front sheet may be glass, transparent ceramic, polymer or any other convenient substantially transparent material, and the back sheet may be metal, glass, ceramic, polymer or any other convenient material. The front sheet 11 may be structured, and may be provided with coatings.

Situated between the front and back sheets is a photovoltaic conversion device 15 comprising one or more PV cells comprising NIP, PIN, NP or PN junctions, patterned and interconnected as is generally known. The PV cells may be based on thin-film silicon, crystalline silicon, germanium, perovskite, dye-sensitised cells, or any other type of PV technology adapted to generate electrical power from light impinging on the light-incident side of the PV module 1.

The PV conversion device 15 is encapsulated on its front side by a front encapsulant layer 13, which seals it to the front sheet 11, and on its back side by a rear encapsulant layer 17. This latter seals the PV conversion device 15 to the back sheet 19, although it may indeed itself form the rear sheet. The encapsulants can be standard substances such as polyolefin, EVA (ethylene-vinyl acetate), ionomer, polyvinyl butyral, modified fluoropolymer or similar. Each of the encapsulant layers 13, 17 is typically between 200 *µ* m and 1mm, or even up to 2 mm thick. Furthermore, multiple front encapsulation layers 13 can be stacked on top of each other. In the case of a transparent (e.g. glass) or non-dark-coloured back sheet, the rear encapsulant layer 17 may be coloured or pigmented with a dark colour (e.g. black, dark brown, dark blue or similar) in order to help disguise interconnects and structuring present in the module. It should be noted that, in the sense of the invention, an encapsulant layer seals one layer to another. As a result, the front encapsulant layer 13 is an internal layer and is hence not an outer layer of the module structure such as a front sheet or a graphic film.

It should be noted that other intermediate layers may be provided between the illustrated layers, and that the layers do not have to be flat and can describe curves or more complex surfaces.

According to the invention, the front encapsulant 13 comprises pigment particles 21 incorporated therein. Specifically, the front encapsulant 13 comprises a first zone 13a and a second zone 13b. The first zone 13a is situated closer to the front sheet 11 (and hence towards the light incident side of the module 1) than the second zone 13b, which is situated closer to the PV conversion device 15 than the first zone 13a. The first zone 31a and second zone 13b are typically directly adjacent to one another and hence are in contact, but the presence of an intermediate zone of encapsulant between them is not excluded.

The first zone 13a comprises a higher concentration of pigment particles 21 than the second zone 13b, which may comprise substantially no pigment particles 21 at all, or simply a lower concentration thereof than in the first zone 13a. If the second zone 13b comprises pigment particles 21, they are provided in a concentration of at most 50%, preferably at most 30%, further preferably at most 20% of the concentration thereof in the first zone 13a. In the case of pigment particles being present in each zone 13a, 13b, these may be the same or different.

Further zones (not illustrated) of the front encapsulant 13 may be provided, on either or both of the front sheet 11 side thereof, or on the PV device 15 side thereof. These further zones would typically be free of pigment particles 21, but it is not to be excluded that they comprise low concentrations of pigment.

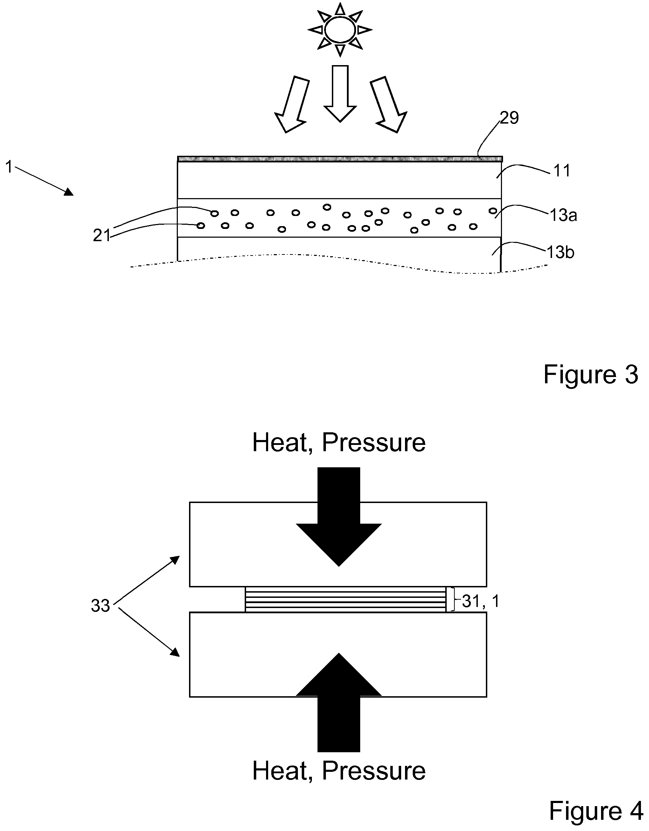

The pigment particles 21 are represented highly schematically, and at least some, preferably at least 50%, further preferably at least 75% (or even substantially all) of the particles typically have a size ranging from 100 nm to 1 µm, most notably from 300-700 nm, and most particularly from 400-600 nm. It is noted that pigment particles are discrete particles, which are distinct from a colorant dispersed at molecular level in the encapsulant or an encapsulant made from an already coloured material. The pigment particles 21 are distributed throughout the thickness of the first zone 13a (and hence not just at or near its surface); if any pigment particles are present in the second zone 13b, they are likewise distributed throughout the thickness of this zone. How the two zones 13a, 13b which comprised by the front encapsulant layer 13 are formed is described below in the context of figure 4. The distribution of the pigment particles 21 can be random, or can form a particular pattern formed when the film from which the first zone 13 is made is extruded. The pigment distribution is maintained by the method of the invention (see below).

A wide variety of pigments can be used, provided that they are chemically stable, are stable under prolonged ultraviolet light exposure either alone or in combination with an appropriate UV stabiliser such as Hindered Amine Light Stabilizers (HALS), hydroxyphenylbenzotriazole, oxanilides, benzophenones, benzotrazoles, hydroxyphenyltriazines and so on. As examples of suitable pigments, titanium oxide or zinc oxide particles may be used to generate a white colour. Yellow, orange, red and brown colours can be generated by using various iron oxides such as Fe₂O₃ for red ochre, or FeO(OH) or Yellow Ochre for yellow. Yellow can also be generated by bismuth vanadate, or Yellow titanium, or Zinc chromate, or stannic sulfide. Green can be generated with chromic oxide or Co/Li/Ti oxides. Blues can be generated e.g. by means of a complex sulphur-containing sodium silicate or Prussian blue, or cobalt stannate. Of course, the invention is not limited to such pigments, and many others are available on the market.

The pigment particles 21 can be provided in concentrations ranging from 0.01 to 10 parts per hundred of the resin (phr) serving as the basis for the front encapsulation layer 13. More particularly, 0.1 to 5 phr, even more particularly 0.1-1 phr of pigment particles 21 can be used, depending on the thickness of the front encapsulation layer 13, thinner encapsulant layers typically benefitting from higher concentrations of pigment particles 21.

The pigment particles 21 absorb part of the visible light incident on the PV device 1 so as to generate the desired colour, and also diffuse light which provides a homogeneous colour and helps to hide the various features of the PV conversion device 15 such as its patterning, the tracks of electrical interconnections between the individual cells, the edges of the individual cells, the colour mismatches between the individual cells and the rear encapsulant 17 and/or backsheet 19, and so on.

This scattering effect is particularly advantageous over simply providing a front encapsulant which is coloured by means of a colorant dispersed therein at a molecular level, since such a colourant results in a much greater degree of optical transparency due to the lack of light scattering and hence does not hide the various features of the PV conversion device 15 as described above.

Furthermore, the scattering effect helps to diffuse the light that passes through the front encapsulant 13 and enters into the photovoltaically-active parts of the PV conversion device 15, increasing the average path length of light through the cell, in a manner similar to a conventional diffusion element incorporated in a PV module 1 on the light-incident side of the PV conversion device 15. Of course, the overall efficiency is reduced in proportion to the light reflected or scattered back towards the light-incident side of the PV device.

The size of the pigment particles 21 can be tuned to increase the transmittance in the infrared range for PV conversion devices 15 which are sensitive to IR light, and interference can be generated between the pigment particles 21 to give shiny, shimmering, or rainbow effects by optimising the pigment particle size and their density in the front encapsulant layer 13. More generally, the pigment particle size and concentration, front encapsulant layer 13 thickness, the thickness of the first zone 13a and so on can be tuned by routine experimentation within the bounds mentioned above in order to achieve the desired colour, optical effect, transmissivity, reflectivity and so on, and there is no particular a priori particle size to particle concentration relationship for any given pigment - this relationship depends simply on the desired optical properties.

In respect of the manufacture of the front encapsulant layer 13, the required quantity of pigment particles 21 can simply be mixed in with the base resin or resin precursor which will form the first zone 13a of the encapsulant layer 13, and optionally that of the second zone 13b if this is also pigmented. If required, an appropriate UV stabiliser (as mentioned above) can also be incorporated into the resin at the same time. This can then be extruded as normal, without any special equipment or techniques.

As a result of this construction, a coloured fritted front glass (or similar) is no longer required as a front sheet 11, and the invention can thus be carried out without specialised equipment and the PV modules 1 can be assembled in conventional lamination devices (see below).

Figure 2 represents another embodiment of a PV module 1 manufactured according to the invention. In this variant, front encapsulant layer 13 and front sheet 11 have been laminated onto the front of a pre-existing prefabricated PV module 27. As a result, the final PV module 1 manufactured according to the invention also comprises an internal front sheet 25 and an internal front encapsulant layer 23, since these layers are already present in the pre-existing prefabricated PV module 27. The remaining layers 15, 17 and 19 are comprised by the prefabricated PV module, are as described above and need not be described again.

This arrangement permits bringing the advantages of the present invention to any commercially-available PV module by retrofitting a front encapsulant layer 13 and front sheet 11 on to the existing module. This is also particularly advantageous since it makes it easier to produce a variety of different modules 1 according to the end-user's requirements. In essence, the manufacturer can maintain a stock of prefabricated standard PV modules 27, and then laminate thereupon the front encapsulant layer 13 and front sheet 11 according to requirements, either selecting an appropriately-coloured front encapsulant layer 13 from stock, or manufacturing it to order.

Figure 3 partially illustrates a further variant of a PV module 1 manufactured according to the invention, comprising a graphic film 29 applied to the light-incident side of the front sheet 11. This graphic film 29 may, for instance, be a polymer film such as a commercially-available PET film, upon which an image, a pattern or similar has been printed by means of any convenient technique. The graphic film 29 may be applied either during lamination (see below), or after manufacture of the otherwise-finished PV module 1.

The graphic film 29 may be applied to either the embodiment of figure 1 or of figure 2, and as a result the rest of the PV module 1 has not been represented in figure 3.

Alternatively, in a non-illustrated embodiment, the graphic film 29 can be laminated between the front encapsulant 13 and the front sheet 11.

As further possibilities which can be applied as appropriate in any of the above embodiments, a polymer layer containing the pigment particles described above may be used as a front sheet 11 e.g. directly in contact with the front encapsulant 13, or may be provided as an extra layer on top of a glass or polymer front sheet. In such cases, the front encapsulant 13 may contain particles according to the invention, or may be conventional. A particularly advantage resin for this particle-containing layer is a fluroolefin such as Lumiflon (from Asahi Glass Co. Ltd), however other polymers are possible.

Figure 4 represents schematically a method of manufacturing a PV module 1 according to the invention.

A layer stack 31 comprising at least the layers 11, 13, 15, 17 and 19, together with any other layers present, is assembled in a lamination device 33. In the case of the embodiment of figure 2, the layer stack comprises a pre-fabricated PV module 27, upon which front encapsulant layer 13 and front sheet 11 (and any other desired layers) have been applied. It should be noted that the layer stack 31 can be assembled in the lamination device 33 either with the light-incident side of the final PV module facing downwards or facing upwards.

Since the front encapsulation layer 13 has two zones 13a, 13b, it is formed from two separate films, a first film 13a which will become the first zone (and hence bears the same reference sign), and a second film 13b which will become the second zone (which also hence bears the same reference sign). The first film 13a hence comprises the particles 21 as discussed above. These are disposed in the correct order in the lamination device 33, together with any extra films disposed on one or other side thereof.

The lamination device may be a vacuum bag laminator, roller-type laminator, or any other convenient type. The lamination device 33 then applies heat and pressure, e.g. at a temperature of 140°C to 180°C and a pressure of up to 1 bar (typically 0.4 bar to 1 bar), for an appropriate length of time, which causes the various encapsulant layers to fuse and thereby to assemble the final PV module 1.

As a result, the PV module 1 manufactured according to the invention can be made in conventional PV processing equipment, without requiring specialised equipment.

The properties of the first and second films 13a, 13b can be optimised in order to better prevent pigment migration during lamination. As mentioned above, in the prior art, as the pigmented encapsulant flows under the application of heat and pressure, the pigment particles may migrate and aggregate. This often results in a very non-uniform coloration where the pigment migrates and where the encapsulant layer ends up with thickness variations, e.g. around the individual cells making up the PV conversion device 15.

The solution to this particular problem lies in the choice of materials for the first and second films 13a, 13b, each of which may for instance have a thickness between 0.05mm and 2mm, preferably between 0.1mm and 1mm.

In essence, the material of the first film 13a is chosen such that the migration of the pigment particles 21 is limited, whereas the material of the second film 13b is chosen for its encapsulation properties and its ability to flow around features such as the details of the underlying PV cells 15, if no intermediate layers are present. To this end, the viscosity of the first film 13a during lamination is chosen to be higher than that of the second film 13b. This higher viscosity limits the lateral flow (in the plane of the film 13a) which prevents pigment migration and hence avoids inhomogeneous distribution of pigments, while the lower viscosity of the second film 13b flows as normal, and hence seals to the underlying layer as normal. Furthermore, the second **film 13b acts** as a "buffer" layer, reducing the tendency of the thickness of the first film 13a to vary due to underlying features such as individual cells.

Furthermore, if the material of the first film 13a has viscoelastic properties, this also further limits changes in the thickness of the final first zone, and hence avoids changes in light absorption as a result.

Several possibilities are open in respect of the choice of encapsulant materials, in dependence of whether the first film 13a is made of crosslinkable polymer or not.

In the first case, the base resin of the first film 13a is not cross-linkable, such as polyethylene (PE), Polypropylene, Poly(etheretherketone), Poly(ethylene terephthalate), Polyamide, Nylon, Poly(methylene oxide), POM, Poly(4-methylpentene), Poly(styrene), Poly(vinyl alcohol), Poly(vinyl chloride), Poly(vinyl fluoride), Poly(vinylidene chloride), Polyurethane, Polyimide, Polycarbonate, Acrylonitrile butadiene styrene, Polyphenylene sulfide, or Styrene acrylonitrile, in which case the required viscosity is obtained by choosing and/or adapting the formulation of the encapsulant. This is a simple task for the skilled person based on the desired film properties during lamination (see below), and in simple terms the second film 13b typically has a lower melting temperature than the first film 13a, and the lamination temperature is chosen such that the viscosity of the second film 13b remains well below that of the first film 13a. Ideally, the complex viscosity of the second film 13b remains at least 20% lower, preferably at least 50% lower, further preferably at least 10 times lower, than that of the first film 13a during lamination. On the basis of the desired properties, corresponding commercial products can be chosen off-the-shelf, or modified appropriately.

More specifically, the desired properties are preferably:
- Complex viscosity > 400,000 Pa.s at 85°C, > 50,000 Pa.s at 105°C, > 1,000 Pa.s at 165°C, the complex viscosity above the actual lamination temperature being irrelevant;
- Tan δ < 0.8 throughout the entire lamination process.

The addition of pigment particles in the ranges mentioned above may increase the viscosity up to 10%.

For reference, complex viscosity is the frequency-dependent viscosity function determined during forced harmonic oscillation of shear stress, and is defined as the complex modulus divided by angular frequency, where complex modulus represents the overall resistance to deformation of the material, regardless of whether that deformation is recoverable, i.e. elastic, or non-recoverable, i.e. viscous. This is measured with a dynamic moving-die rheometer or similar tool, in the present case at 1Hz frequency and 10% strain. Tan δ , also known as the "Loss Tangent", is the tangent of the phase angle characterising the ration of viscous modulus (G") to elastic modulus (G'), and quantifies the presence and extent of elasticity in a fluid. Tan δ values of less than 1.0 indicate elastic-dominant (i.e. solid-like) behaviour and values greater than unity indicate viscous-dominant (i.e. liquid-like) behaviour, again at 1Hz frequency and 10% strain.

Paired with this non-crosslinkable first film 13a is a second film 13b with the following properties:
- Complex viscosity < 100,000 Pa.s at 85°C, < 20,000 Pa.s at 105°C, < 15,000 Pa.s at 165°C (provided that it is still sufficiently lower than the viscosity of the first film 13a as mentioned above, the complex viscosity above the actual lamination temperature again being irrelevant);
- Tan δ > 0.9, preferably > 1.2 at the lamination temperature.

It should be noted that if the base resin of the second film 13b does not exhibit sufficient creep resistance, it can be at least partially crosslinked prior to and/or during, and/or after lamination.

In the case in which the first film 13a is crosslinked, the degree of pre-curing of this film contributes to determining its viscosity. Ideal parameters are as follows:
- Complex viscosity > 20,000 Pa.s at 85°C, > 15,000 Pa.s at 105°C, > 5,000 Pa.s at 165°C, the complex viscosity above the actual lamination temperature being irrelevant;
- Tan δ < 0.8 throughout the entire lamination process.

**Note** that those required properties can be at least partially obtained by performing pre-crosslinking of the first film 13a through different curing mechanisms, e.g. radiation curing, moisture curing, peroxide-initiated curing.

Corresponding parameters for the second film 13b are as follows:
- Complex viscosity < 100,000 Pa.s at 85°C, < 20,000 Pa.s at 105°C, < 10,000 Pa.s at 165°C;
- Tan δ > 0.9, preferably > 1.2, at least at the lamination temperature.

When the encapsulant of the first film 13a is pre-cross-linked, the same base resin can be used for both layers, with only the first film 13a being pre-cured.

It should be noted that if the viscosity of the first film 13a is too high under lamination conditions to ensure good wetting of the adjacent layer (e.g. the front sheet 11) and adequate adhesion thereto, a supplementary encapsulant film can be placed between first film 13a and said adjacent layer, this film being conventional encapsulant material of conventional viscosity and acting in an analogous manner to second film 13b.

In any case, the general principle is that:
- the first film 13a has tan δ < 0.8 throughout the entire lamination process to give it a more solid-like behaviour;
- the second film 13b has tan δ > 0.9, preferably > 1.2, at least at the lamination temperature, to give it more liquid-like behaviour; and
- the viscosity of the second film 13b does not exceed 80% of the viscosity of the first film 13a at least at the lamination temperature, preferably does not exceed 50% of the viscosity of the first film 13a, and further preferably does not exceed 10% of said viscosity.

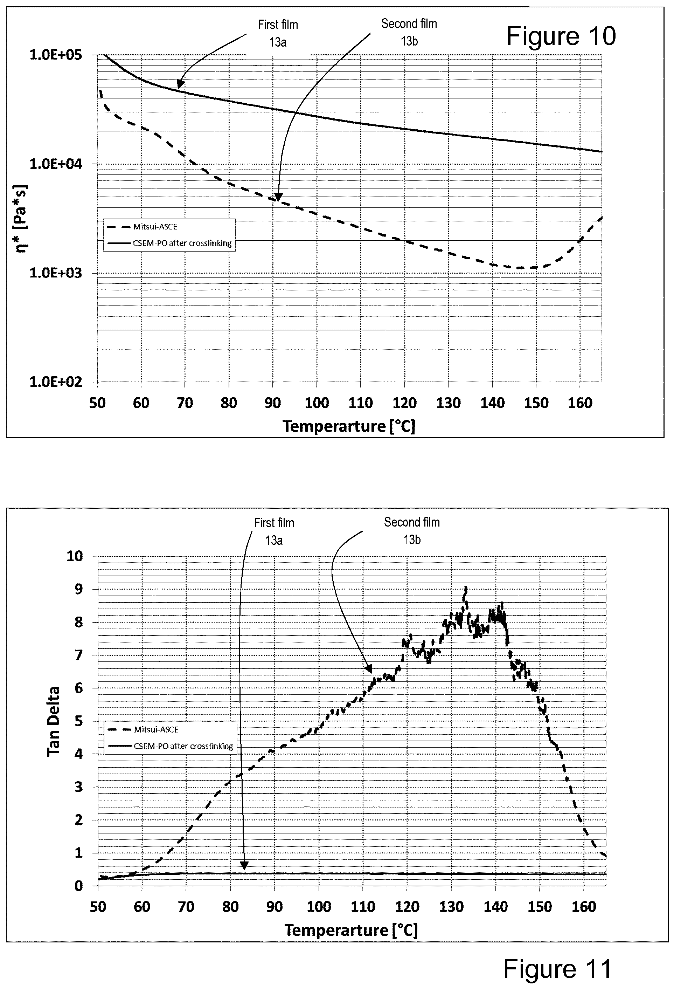

Figure 10 illustrates a graph of complex viscosity (logarithmic vertical axis) vs temperature (linear horizontal axis), and figure 11 illustrates values of tan δ (linear scales) for examples of materials for the first film 13a and second film 13b. More specifically, these materials are XLPO encapsulant developed in house at CSEM and XLPO grade ASCE supplied by Japanese company Mitsui chemicals, respectively. Throughout the whole graph, right up to approximately 165°C, the complex viscosity *η** of the second film 13b does not even reach 50% of that of the first film 13a, and is hence well within limits of acceptability (80% maximum). In this example, lamination temperatures of up to about 165°C are hence possible, when tan δ of the second film 13b falls below 0.9. Ideally, the complex viscosity of the second film 13b should not exceed 10% of that of the first film 13a, and tan δ of the second film 13b should remain above 1.2, indicating a maximum lamination temperature around 160°C however.

When the first film 13a is not cross-linkable, the viscosity intrinsically decreases as the temperature increases, and hence the material of the second film 13b should be carefully chosen so as to endure a sufficient difference in viscosity throughout the entire lamination process, and the maximum temperature should likewise be carefully chosen. If required, e.g. for use in hot climates, the second film 13b can also be cross-linkable in order to have sufficient creep resistance.

When the first film 13a is cross-linkable and it is not fully crosslinked after a pre-crosslinking step carried out earlier, it has a lower viscosity during early stages of lamination which helps to fill voids etc. before cross-linking increases its viscosity and gives it greater mechanical strength. At any given moment during lamination, its viscosity and Tan Delta depend on the temperature and the degree of reticulation (cross-linking) of the film, which may further develop as the lamination progresses. The intrinsic drop in viscosity and increase in Tan Delta as temperature increases are hence compensated by increasing reticulation, giving a much wider choice of material for the second film 13b since it is relatively easy to choose a material with a sufficiently-lower viscosity during the lamination process. Indeed, selection of a cross-linkable resin for the second film 13b for good creep resistance is easier in this case than in the case of a non-cross-linkable first film 13a.

In both cases, the interface between the two films 13a, 13b after lamination is perfect, and free of voids. Furthermore, cross-diffusion of the pigment particles 21 is minimal across the interface.

Specific examples of pairs of materials for the first film 13a and second film 13b are given in the following table. The commercial references given represent unchanging formulations and hence assure repeatability.

| | **First film 13a** | **Second film 13b** |
|---|---|---|
| **1.** | Padanaplast Polidan G420 | Hangzhou First Enlight XUS |
| **2.** | Mitsui Admer NF837E | STR Solar 15530 |
| **3.** | Mitsui Admer NF410E | Mitsui ASCE |
| **4.** | Dow XUS 38660 (cross-linkable) | Dai Nippon Printing (DNP) Solar CVF |
| **5.** | ExxonMobil Escorene UL02528 CC (cross-linkable) | Mitsui ASCE |

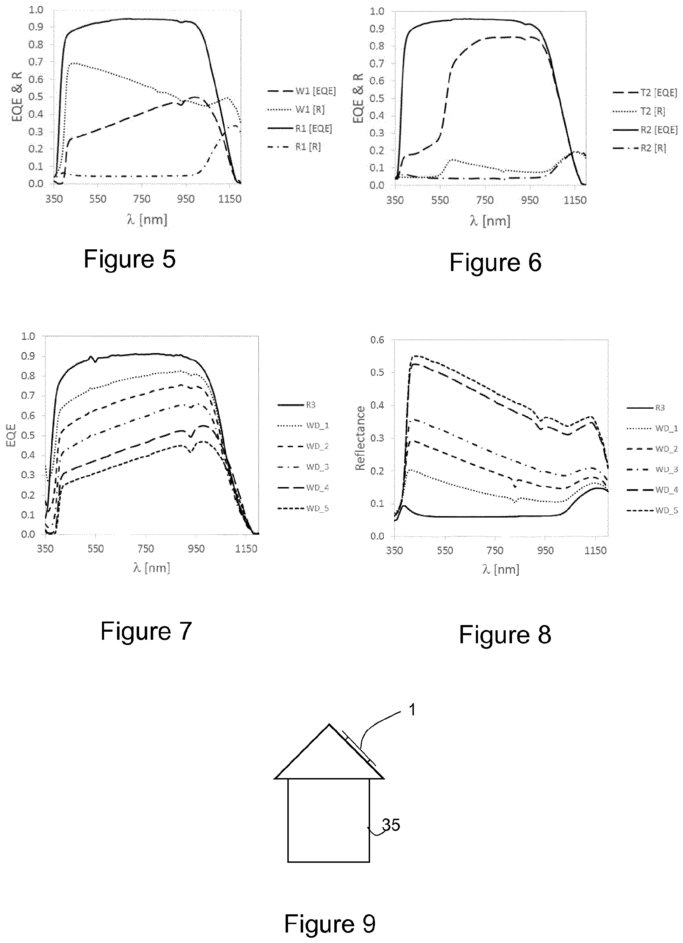

Figure 5 illustrates a graph of experimental results obtained by manufacturing a PV module 1 according to the embodiment of figure 2 but without the second zone 13b, in order to illustrate the effects of certain combinations of encapsulants and pigments. In this case, the front encapsulant layer 13 was made with Dow Engage PV POE XUS 38660.00 polyolefin-based base resin, 1 phr DuPont Ti-Pure R-960 titanium dioxide-based pigment, with no further additives. Median pigment particle size was 500 nm.

The pigment particles were added and mixed manually with the base resin and extruded at 170°C by means of a twin-screw extruder to obtain a white cross-linkable polyolefin film with a thickness of 0.85mm.

The resulting white front encapsulation sheet was combined with a 50 *µ* m thick ETFE front sheet, and laminated onto a prefabricated PV module at a temperature of 165°C and pressure of approximately 1 bar (±0.99 bar) for 720 seconds.

The metal connections of the PV module were blackened and the backsheet 19 was also black coloured to reduce contrast.

The graph of figure 5 illustrates the external quantum efficiency (EQE) and reflectance (R) over the wavelength range of 350 nm to just over 1150nm, for the PV module 1 manufactured according to the invention as described immediately above (W1), and contrasted with a reference cell with the same construction but built using a clear front encapsulant layer 13 (R1). As can be seen, the EQE fell and the reflectance increased over a wide bandwidth of wavelengths of light.

Furthermore, the cell performance and colour expressed in "Lab" colour space coordinates were also measured, the results of which appear in the following table:

| | Module Current | Relative Performance | Colour | Colour | Colour |
|---|---|---|---|---|---|
| ID | J_{SC} [mA/cm²] | Δ J_{SC} [%] | L | a | b |
| R1 | 39.0 | - | 25.3 | 0.46 | -2.70 |
| T1 | 16.5 | -57.7 | 84.8 | -1.39 | -2.44 |

As can be seen from the table, the module 1 thus constructed has a white colour, with current losses of approximately 58%.

Figure 6 illustrates a graph of experimental results obtained by manufacturing another PV module 1 according to the embodiment of figure 2 (again without the underlying zone 13b), wherein the front encapsulant layer 13 was made with ExxonMobil Escorene Ultra UL 00728CC EVA copolymer base resin, with 0.05 wt.% of Scholz Red 110M pigment particles dispersed therein.

The red pigment particles were mixed with the base resin manually, which was then extruded at 95°C to create a 0.9mm thick film of front encapsulant. This was then combined with a 100 *µ* m thick ETFE front sheet and laminated at 150°C at a pressure of substantially 1 bar for 720 seconds. As per the previous example, the metal connections were blackened and a black coloured backsheet 19 was used.

The resulting PV module has a terracotta colour particularly suitable for mounting on roofs in areas where terracotta tiles are common, and the graph of figure 6 again shows the EQE and reflectivity results obtained for this PV module (T2) compared to a similarly-constructed reference module (R2) using conventional clear front encapsulant. In this case, the EQE of the terracotta module T2 is only significantly diminished below about 650nm wavelength, and the reflectance profile only rises slightly above about 600nm wavelength.

Furthermore, the performance and colour results are expressed in the following table:

| | Current | Relative Performance | Colour | Colour | Colour |
|---|---|---|---|---|---|
| ID | J_{SC} [mA/cm²] | Δ J_{SC} [%] | L | a | b |
| R2 | 38.9 | - | 24.0 | 1.65 | -3.95 |
| W2 | 27.8 | -28.5 | 34.6 | 16.55 | 16.24 |

Current losses are limited to 28.5%, which compares favourably to the 57.7% losses measured for the previous white module.

Figure 7 illustrates a graph of EQE, and figure 8 illustrates a graph of reflectance, with respect to wavelength of light obtained by PV modules constructed according to figure 1 (again without the underlying zone 13b).

In this series of experiments, various PV modules manufactured according to the invention were constructed according to the structure of figure 1, comprising various front encapsulants made up from one or more of the following layers:

| ID | Pigment concentration | Thickness [mm] |
|---|---|---|
| D_1 | 0.05 wt% | 0.55 |
| D_2 | 0.15 wt% | 0.55 |
| D_3 | 0.25 wt% | 0.55 |

The base resin was Polidiemme FE1252 EP modified polyolefin from Padanaplast, and the pigment particles were Ti-Pure R-960 from DuPont, as mentioned above. The base resin and pigment were first compounded on a twin-screw extruder at 170°C and pelletised. Subsequently, the pellets were extruded at 170°C on a single-screw extruder to form films with the stated thickness. The pigmentation of these films was adapted so as to give a light diffusive effect and a white colour, and the following modules were constructed:

| ID | Front encapsulant |
|---|---|
| R3 | Clear (reference) |
| WD_1 | D_1 |
| WD_2 | D_2 |
| WD_3 | D_3 |
| WD_4 | D_2 + D_4 (stacked) |
| WD_5 | D_3 + D_3 (stacked) |

Considering the graphs of figures 7 and 8, the PV module WD_3 represents a good tradeoff between performance and aesthetics.

The same PV modules were also subjected to a performance test and a 380-780nm reflectance test, and the results are reproduced below:

| | Current | Relative performance | Reflectance |
|---|---|---|---|
| ID | J_{SC} [mA/cm²] | Δ J_{SC} [%] | R₃₈₀₋₇₈₀ₙₘ [%] |
| R3 | 36.2 | - | 6.3 |
| WD_1 | 31.7 | -12.4 | 15.6 |
| WD_2 | 27.9 | -22.9 | 23.7 |
| WD_3 | 23.3 | -35.6 | 29.8 |
| WD_4 | 18.7 | -48.3 | 46.1 |
| WD_5 | 15.8 | -56.3 | 48.8 |

As a final example, three modules according to the embodiment of figure 1 (again without the underlying zone 13b) with an applied image layer 29 according to figure 3 were fabricated. A reference module again comprised a clear front encapsulant 13, and then two others with front encapsulant layers 13 according to WD_3 and WD_4 as described above were also fabricated. The image graphic on the reference module was hardly visible, whereas it was clearly visible on the other two.

The performance results of the three modules are reproduced below:

| ID | Current J_{SC} [A] | Relative performance for current [%] | Power [W] | Relative performance for power [%] |
|---|---|---|---|---|
| Reference | 5.57 | - | 2.597 | - |
| WD_3 | 4.83 | -13.3 | 2.249 | -13.4 |
| WD_4 | 3.64 | -34.6 | 1.698 | -34.6 |

Again, the front encapsulant WD_3 represents a good compromise between aesthetics and power / current loss compared to an uncoloured reference.

Finally, figure 9 illustrates a photovoltaic module 1 manufactured according to the invention mounted on the roof of a building structure 35. Alternatively, the PV module 1 can be mounted to an exterior wall, or integrated into the structure of the wall and/or roof, e.g. as cladding. In general terms, the PV module 1 can be mounted on or in the structure of the building 35.

Although the invention has been described in terms of specific embodiments, variations thereto are possible without departing from the scope of the invention as defined in the appended claims.

## Claims

1. Method of manufacturing a photovoltaic module (1) comprising the steps of:
- providing a lamination device (33);
- disposing in said lamination device (33) a layer stack (31) comprising:
- a front sheet (11) intended to be arranged on a light incident side of said photovoltaic module (1);
- a back sheet (19) intended to be arranged on an opposite side of said photovoltaic module (1) to said front sheet (11);
- a photovoltaic conversion device (15) disposed between said front sheet (13) and said back sheet (19);
- at least one front encapsulation layer (13) disposed between said photovoltaic conversion device (15) and said front sheet (11), said front encapsulation layer (13) comprising pigment particles (21) distributed therein;
- applying heat and pressure to said layer stack (31) so as to assemble it into said photovoltaic module (1),
wherein said front encapsulation layer (13) comprises a first film (13a) and a second film (13b), said first film (13a) being situated closer to said front sheet (11) than said second film (13b) and comprising a higher concentration of pigment particles than said second film (13b),
**characterized in that** said first film (13a) is at least partially cross-linked and has a complex viscosity greater than 20,000 Pa.s at 85°C, greater than 15,000 Pa.s at 105°C, and greater than 5,000 Pa.s at 165°C , and wherein said second film (13b) has a complex viscosity less than 100,000 Pa.s at 85°C, less than 20,000 Pa.s at 105°C, and less than 10,000 Pa.s at 165°C, the 165°C conditions being optional if lamination temperature is less than 165°C.

2. Method of manufacturing a photovoltaic module (1) comprising the steps of:
- providing a lamination device (29);
- disposing in said lamination device (29) a layer stack comprising:
- a prefabricated photovoltaic module (27);
- at least one front encapsulation layer (13) disposed on a light incident side of said prefabricated photovoltaic module (27), said front encapsulation layer (13) comprising pigment particles (21) distributed therein;
- a front sheet (11) arranged on a light incident side of said at least one front encapsulation layer (13);
- applying heat and pressure to said layer stack (31) so as to assemble it into said photovoltaic module (1);
**characterised in that** said front encapsulation layer (13) comprises a first film (13a) and a second film (13b), said first film (13a) being situated closer to said front sheet (11) than said second film (13b) and comprising a higher concentration of pigment particles than said second film (13b).

3. Method according to claim 1 or 2, wherein said first film (13a) has a higher viscosity than said second film (13b) during said application of heat and pressure.

4. Method according to claim 3, wherein said first film (13a) has a tan δ value of less than 0.8, and said second film (13b) has a tan δ value of at least 0.9, preferably at least 1.2, during said application of heat and pressure, and wherein, at the temperature of lamination, the viscosity of the second film (13b) is at most 80%, preferably at most 50%, of the viscosity of the first film (13a).

5. Method according to one of claims 1-4, wherein at least some of said pigment particles (21) have a diameter ranging from 100 nm to 1 µm, preferably 300-700 nm, more preferably 400-600 nm.

6. Method according to one of claims 1-5, wherein said pigment particles (21) are provided in said front encapsulation layer (13) in a mass concentration ranging from 0.01 to 10 parts per hundred of resin.

7. Method according to one of claims 1-6, wherein said pigment comprises at least one of:
• Zinc-based pigments;
• Titanium-based pigments;
• Iron-based pigments;
• Chromium-based pigments;
• Bismuth-based pigments;
• Cobalt-based pigments;
• Aluminium-based pigments;
• Tin-based pigments;
• Copper-based pigments.

8. Method according to one of claims 1-7, wherein said front encapsulation layer (13) is manufactured by mixing said pigment particles (21) with a base resin, and extruding said front encapsulation layer (13) as a film.

## Patentansprüche

1. Verfahren zur Herstellung eines photovoltaischen Moduls (1), das die folgenden Schritte umfasst:
- Bereitstellen einer Laminiervorrichtung (33);
- Anordnen eines Schichtstapels (31) in der Laminiervorrichtung (33), umfassend:
- eine vordere Schicht (11), die dazu bestimmt ist, auf einer Lichteinfallsseite des photovoltaischen Moduls (1) angeordnet zu werden;
- eine hintere Schicht (19), die dazu bestimmt ist, auf einer der vorderen Schicht (11) gegenüberliegenden Seite des photovoltaischen Moduls (1) angeordnet zu werden;
- eine photovoltaische Umwandlungsvorrichtung (15), die zwischen der vorderen Schicht (13) und der hinteren Schicht (19) angeordnet ist;
- mindestens eine vordere Einkapselungsschicht (13), die zwischen der photovoltaischen Umwandlungsvorrichtung (15) und der vorderen Schicht (11) angeordnet ist, wobei die vordere Einkapselungsschicht (13) darin verteilte Pigmentteilchen (21) umfasst;
- Anwenden von Wärme und Druck auf den Schichtstapel (31), um ihn zu dem photovoltaischen Modul (1) zusammenzusetzen,
wobei die vordere Einkapselungsschicht (13) einen ersten Film (13a) und einen zweiten Film (13b) umfasst, wobei der erste Film (13a) näher an der vorderen Schicht (11) angeordnet ist als der zweite Film (13b) und eine höhere Konzentration von Pigmentteilchen umfasst als der zweite Film (13b),
**dadurch gekennzeichnet, dass** der erste Film (13a) zumindest teilweise vernetzt ist und eine komplexe Viskosität von mehr als 20'000 Pa.s bei 85°C, mehr als 15'000 Pa.s bei 105°C und mehr als 5'000 Pa.s bei 165°C aufweist, und wobei der zweite Film (13b) eine komplexe Viskosität von weniger als 100'000 Pa.s bei 85°C, weniger als 20'000 Pa.s bei 105°C und weniger als 10'000 Pa.s bei 165°C aufweist, wobei die 165°C-Bedingungen fakultativ sind, wenn die Laminierungstemperatur weniger als 165°C beträgt.

2. Verfahren zur Herstellung eines photovoltaischen Moduls (1), das die folgenden Schritte umfasst:
- Bereitstellen einer Laminiervorrichtung (29);
- Anordnen eines Schichtstapels in der Laminiervorrichtung (29), der Folgendes umfasst:
- ein vorgefertigtes photovoltaisches Modul (27);
- mindestens eine vordere Einkapselungsschicht (13), die auf einer Lichteinfallsseite des vorgefertigten photovoltaischen Moduls (27) angeordnet ist, wobei die vordere Einkapselungsschicht (13) darin verteilte Pigmentteilchen (21) umfasst;
- eine vordere Schicht (11), die auf einer Lichteinfallsseite der mindestens einen vorderen Einkapselungsschicht (13) angeordnet ist;
- Anwenden von Wärme und Druck auf den Schichtstapel (31), um ihn zu dem photovoltaischen Modul (1) zusammenzusetzen;
**dadurch gekennzeichnet, dass** die vordere Einkapselungsschicht (13) einen ersten Film (13a) und einen zweiten Film (13b) umfasst, wobei der erste Film (13a) näher an der vorderen Schicht (11) angeordnet ist als der zweite Film (13b) und eine höhere Konzentration von Pigmentpartikeln umfasst als der zweite Film (13b).

3. Verfahren nach Anspruch 1 oder 2, wobei der erste Film (13a) während der Anwendung von Wärme und Druck eine höhere Viskosität als der zweite Film (13b) aufweist.

4. Verfahren nach Anspruch 3, wobei der erste Film (13a) einen tan δ-Wert von weniger als 0,8 und der zweite Film (13b) einen tan δ-Wert von mindestens 0,9, vorzugsweise mindestens 1,2, während der Anwendung von Wärme und Druck aufweist, und wobei die Viskosität des zweiten Films (13b) bei der Laminierungstemperatur höchstens 80 %, vorzugsweise höchstens 50 %, der Viskosität des ersten Films (13a) beträgt.

5. Verfahren nach einem der Ansprüche 1-4, wobei zumindest einige der Pigmentteilchen (21) einen Durchmesser im Bereich von 100 nm bis 1 µm, vorzugsweise 300-700 nm, noch bevorzugter 400-600 nm, aufweisen.

6. Verfahren nach einem der Ansprüche 1-5, wobei die Pigmentteilchen (21) in der vorderen Einkapselungsschicht (13) in einer Massenkonzentration im Bereich von 0,01 bis 10 Teilen pro Hundert des Harzes vorgesehen sind.

7. Verfahren nach einem der Ansprüche 1-6, wobei das Pigment mindestens eines der folgenden umfasst:
- Pigmenten auf Zinkbasis;
- Pigmenten auf Titanbasis;
- Pigmenten auf Eisenbasis;
- Pigmenten auf Chrombasis;
- Pigmenten auf Bismutbasis;
- Pigmenten auf Kobaltbasis;
- Pigmenten auf Aluminiumbasis;
- Pigmenten auf Zinnbasis;
- Pigmenten auf Kupferbasis.

8. Verfahren nach einem der Ansprüche 1-7, wobei die vordere Einkapselungsschicht (13) durch Mischen der Pigmentteilchen (21) mit einem Basisharz und Extrudieren der vorderen Einkapselungsschicht (13) als Film hergestellt wird.

## Revendications

1. Procédé de fabrication d'un module photovoltaïque (1) comprenant les étapes suivantes :
- fournir un dispositif de laminage (33) ;
- disposer dans ledit dispositif de laminage (33) un empilement de couches (31) comprenant :
- une feuille avant (11) destinée à être disposée sur une face d'incidence lumineuse dudit module photovoltaïque (1) ;
- une feuille arrière (19) destinée à être disposée sur une face dudit module photovoltaïque (1) opposée à ladite feuille avant (11) ;
- un dispositif de conversion photovoltaïque (15) disposé entre ladite feuille avant (13) et ladite feuille arrière (19) ;
- au moins une couche d'encapsulation avant (13) disposée entre ledit dispositif de conversion photovoltaïque (15) et ladite feuille avant (11), ladite couche d'encapsulation avant (13) comprenant des particules de pigment (21) réparties dans cette dernière ;
- appliquer de la chaleur et de la pression à ladite pile de couches (31) afin de l'assembler dans ledit module photovoltaïque (1),
dans lequel ladite couche d'encapsulation avant (13) comprend un premier film (13a) et un second film (13b), ledit premier film (13a) étant situé plus près de ladite feuille avant (11) que ledit second film (13b) et comprenant une concentration de particules de pigment plus élevée que ledit second film (13b),
**caractérisé en ce que** ledit premier film (13a) est au moins partiellement réticulé et présente une viscosité complexe supérieure à 20'000 Pa.s à 85°C, supérieure à 15'000 Pa.s à 105°C, et supérieure à 5'000 Pa.s à 165°C, et dans lequel ledit second film (13b) présente une viscosité complexe inférieure à 100'000 Pa.s à 85°C, inférieure à 20'000 Pa.s à 105°C, et inférieure à 10'000 Pa.s à 165°C, les conditions de 165°C étant facultatives si la température de laminage est inférieure à 165°C.

2. Procédé de fabrication d'un module photovoltaïque (1) comprenant les étapes suivantes
- fournir un dispositif de laminage (29) ;
- disposer dans ledit dispositif de laminage (29) une pile de couches comprenant :
- un module photovoltaïque préfabriqué (27) ;
- au moins une couche d'encapsulation avant (13) disposée sur une face d'incidence lumineuse dudit module photovoltaïque préfabriqué (27), ladite couche d'encapsulation avant (13) comprenant des particules de pigment (21) réparties dans cette dernière ;
- une feuille avant (11) disposée sur une face d'incidence lumineuse de ladite au moins une couche d'encapsulation avant (13) ;
- appliquer de la chaleur et de la pression à ladite pile de couches (31) afin de l'assembler dans ledit module photovoltaïque (1) ;
**caractérisé en ce que** ladite couche d'encapsulation avant (13) comprend un premier film (13a) et un second film (13b), ledit premier film (13a) étant situé plus près de ladite feuille avant (11) que ledit second film (13b) et comprenant une concentration de particules de pigment plus élevée que ledit second film (13b).

3. Procédé selon la revendication 1 ou 2, dans lequel ledit premier film (13a) a une viscosité plus élevée que ledit second film (13b) pendant ladite application de chaleur et de pression.

4. Procédé selon la revendication 3, dans lequel ledit premier film (13a) a une valeur tan δ inférieure à 0,8, et ledit second film (13b) a une valeur tan δ d'au moins 0,9, de préférence d'au moins 1,2, pendant ladite application de chaleur et de pression, et dans lequel, à la température de laminage, la viscosité du second film (13b) est au plus égale à 80 %, de préférence au plus égale à 50 %, de la viscosité du premier film (13a).

5. Procédé selon l'une des revendications 1 à 4, dans lequel au moins certaines desdites particules de pigment (21) ont un diamètre compris entre 100 nm et 1 µm, de préférence entre 300 et 700 nm, plus préférentiellement entre 400 et 600 nm.

6. Procédé selon l'une des revendications 1 à 5, dans lequel lesdites particules de pigment (21) sont présentes dans ladite couche d'encapsulation frontale (13) dans une concentration massique allant de 0,01 à 10 parties pour cent de résine.

7. Procédé selon l'une des revendications 1 à 6, dans lequel ledit pigment comprend au moins l'un de :
- Pigments à base de zinc ;
- Pigments à base de titane ;
- Pigments à base de fer ;
- Pigments à base de chrome ;
- Pigments à base de bismuth ;
- Pigments à base de cobalt ;
- Pigments à base d'aluminium ;
- Pigments à base d'étain ;
- Pigments à base de cuivre.

8. Procédé selon l'une des revendications 1 à 7, dans lequel ladite couche d'encapsulation avant (13) est fabriquée en mélangeant lesdites particules de pigment (21) avec une résine de base, et en extrudant ladite couche d'encapsulation avant (13) sous forme de film.
